# EUROPEAN PATENT APPLICATION

(11) **EP 4 847 924 A1**
(43) Date of publication of application: **02.12.2026**
(21) Application number: 26180139.3
(22) Date of filing: 21.05.2026
(51) Int. Cl.: G01R 22/06

(54) **UNIVERSAL ADAPTER FOR SMART ELECTRICITY METERS**

(30) Priority: 28.05.2025 CH 5882025
(71) Applicant: whatwatt AG, 1568 Portalban (CH)
(72) Inventor: Janek, Szymon, 20-583 Lublin (PL)
(74) Representative: BOVARD AG

(57) **Abstract**

The invention relates to a universal adapter for smart electricity meters capable of automatically adapting to various meter communication standards, including P1, M-Bus, Kamstrup HAN, and NES/MEP, through a single RJ-12 connector. The adapter features a hardware-based interface detection and adaptation circuit configured to automatically adjust signal voltage levels, power supply configurations, and communication line parameters such as pull-up resistor connections and current limiting according to the detected meter interface standard. This ensures safe, reliable, and collision-free communication with multiple meter types without requiring dedicated adapters for each interface. Additionally, the adapter supports IEC 62056-21 compliant optical communication and optical pulse counting, enhancing its versatility in integrating with diverse metering infrastructures.

## Description

### Technical field of the invention

The present invention relates to adapters for smart electricity meters, and in particular to a universal communication interface adapter for various meter standards.

### Background of the invention

With the proliferation of smart electricity meters from different manufacturers, a need has arisen to read their data by external devices. There are known prior art adapters enabling communication with meters, but they are usually dedicated to a specific interface standard of a given meter. In practice, each type of meter (for example, the Dutch P1 port compliant with DSMR/NTA 8130, the European M-Bus per EN 13757, the manufacturer-specific Kamstrup HAN interface, or the NES/OSGP port known as MEP) requires a separate module or wiring.

This causes installation complications, the need to use many different adapters, and increased costs of implementing and maintaining a remote meter reading system. Moreover, incorrectly connecting an incompatible device to the wrong meter port risks loss of communication or even electrical damage to devices. For example, the M-Bus port provides a voltage on the order of tens of volts - accidentally connecting such a line to a port expecting much lower voltages could cause damage. Meanwhile, the P1 interface provides a +5 V supply and uses an open-collector data line - improperly connecting a device not adapted to this standard can prevent communication. Therefore, there is a clear need to develop a universal adapter that, with a single device, ensures safe, automatic electrical compatibility with different meter interface standards, eliminating the need for many specialized converters.

### Summary of the invention

The invention is a universal adapter for smart electricity meters equipped with a single physical connector (RJ-12 type) which, thanks to a special adaptation circuit, automatically recognizes which meter interface standard it has been connected to and adjusts the electrical parameters of its communication to the requirements of that standard. The adapter according to the invention provides universal compatibility with multiple meter protocols and interfaces (including P1, M-Bus, Kamstrup, NES/MEP) without any user intervention or additional modules.

The essence of the solution is automatic adaptation of the TX/RX signal voltage levels, the configuration of the communication lines, and the power supply. This includes, among others, switching the interface circuitry supply voltage (5 V or 3.3 V) depending on the detected port, enabling or disconnecting a pull-up resistor for an open-collector data line, and activating the appropriate transceiver path (e.g. the M-Bus channel). The adapter contains a bridge rectifier in the M-Bus interface path, which guarantees independence from the polarity of the bus wiring. There are also built-in current limiters ensuring that the current draw from the meter remains within the allowable range for the given interface (for example, limited to approx. 11.5 mA for M-Bus, which corresponds to the load of ~7 standard slave devices). Thanks to the unique assignment of signals to the RJ-12 connector pins, the adapter avoids dangerous signal collisions - for example, the high-voltage line from the M-Bus/MEP interface (around 26 V) is disconnected in low-voltage modes (e.g. when working with a P1 port), which prevents too high a voltage from being applied to devices not designed for that standard.

The invention further provides the capability to work with a typical optical communication head compliant with the IEC 62056-21 standard (formerly IEC 1107), which uses an IR diode and a phototransistor. The entire adaptation circuit operates in hardware - the detection of the voltage level and the switching of the configuration occur without software involvement, ensuring reliable and safe operation even in the event of a controlling software failure. As a result, the adapter according to the invention enables automatic, non-intrusive communication with meters of various types using a single device, simplifying installation and reducing integration costs.

Preferably, the adapter may comprise one or more of the following features:
- Universal RJ-12 connector with a unique pin assignment to signals of different standards, which ensures isolation of unused lines and eliminates signal conflicts (e.g. safe whether connected to an M-Bus or P1 interface).
- Analog voltage detection and automatic interface adaptation circuit - a hardware mechanism (comparators, switches, etc.) that detects the type of connected port and automatically switches the adapter's electrical configuration. This circuit switches, among other things, the interface circuitry supply between 5 V and 3.3 V, and connects/disconnects a pull-up resistor according to the standard's requirements (it operates entirely in hardware, fail-safe in case of a master software failure).
- Integrated M-Bus channel - built-in M-Bus transceiver with a diode rectifier at the input (diodes D1-D4 in the schematic) and a current limiting circuit (blocks B3, B5), enabling the adapter to be powered from the bus and exchange current-modulated data in accordance with EN 13757. This solution ensures correct operation regardless of line polarity and protects the meter from overload (the adapter draws at most ~11.5 mA from M-Bus and <40 mA from the MEP port).
- Dynamic TX/RX signal level matching - automatic switching between ~5 V and ~3.3 V levels so that signals always remain within the acceptable range for the given meter. This also includes automatic data line biasing: adding pull-up resistor R1 only when required (e.g. for a P1 port - open collector) and omitting it in standards with an active driver (e.g. Kamstrup).
- Optical interface support - the ability to directly connect an IR optical head (IEC 62056-21) or an optical LED sensor. This extends the adapter's functionality to reading meters not equipped with an electrical communication port, providing two-way optical communication or pulse counting.

According to advantageous embodiments of the invention, some or all of the above elements together may form a device capable of electrically adapting to nearly any meter, providing compatibility with the P1 (DSMR/NTA 8130), M-Bus (EN 13757-2/3), Kamstrup OMNIPOWER HAN, and NES Gen3/Gen4 MEP (OSGP Alliance) standards. In doing so, the invention addresses the problems known in the prior art - it simplifies installation (one universal adapter instead of many), minimizes the risk of damage from incorrect connections, and reduces the costs of integrating smart meters with remote monitoring systems.

### Brief description of the drawings

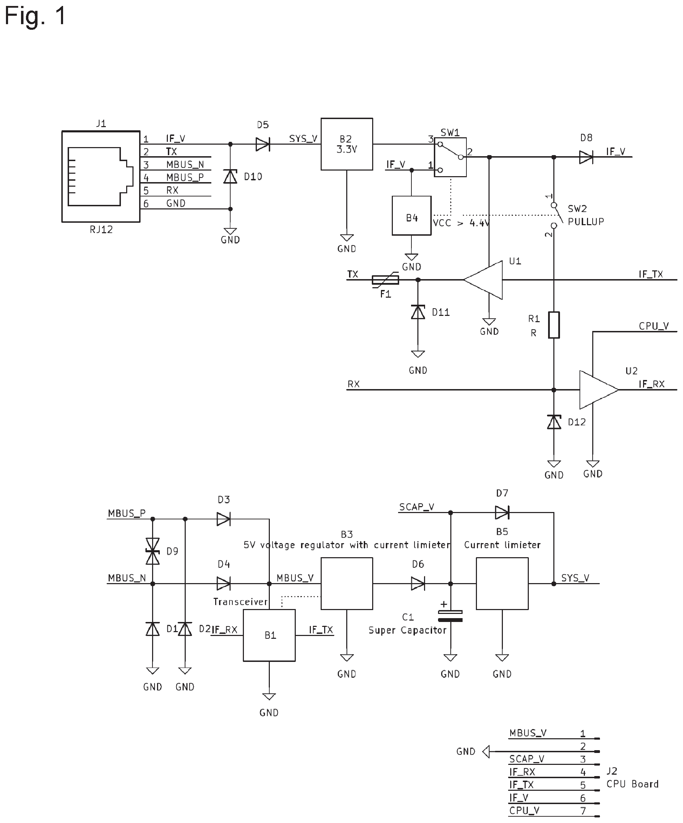

Fig. 1: Block diagram of an adapter according to an embodiment of the invention, and
Fig. 2: A table showing the assignment of RJ-12 pins in an adapter according to an embodiment of the invention to the signals of respective interfaces.

### Detailed description of the illustrated embodiments

### Adapter Architecture and RJ-12 Connector

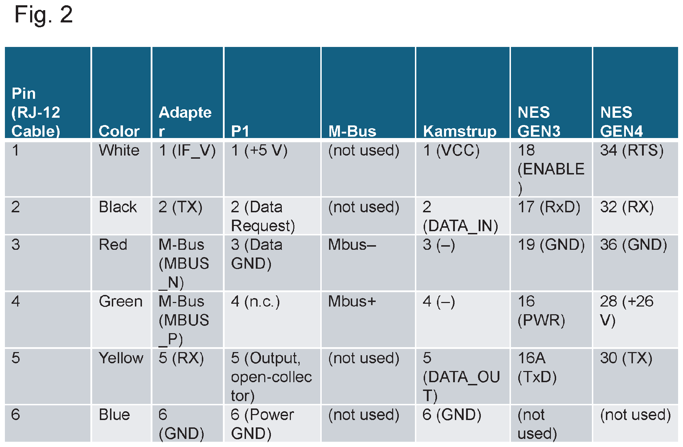

The adapter has a single universal 6-pin RJ-12 connector, whose individual contacts are assigned to functions corresponding to various meter standards. Figure 2 shows the assignment of the RJ-12 pins in the adapter to the signals of the respective interfaces. It should be noted that M-Bus typically uses only two wires (Mbus- and Mbus+) on pins 3 and 4 and "n.c." stands for "not connected."

As seen, the different interface types use different combinations of lines. The adapter is designed such that in each configuration only the circuits that are required are active, while the others remain isolated. For example, pin 4 (MBUS_P) carries a high voltage from the M-Bus or NES/MEP bus, but in P1 mode this pin is physically disconnected (no connection), so dangerously high voltage never reaches a P1 device. Similarly, in the Kamstrup or P1 modes, the unused middle RJ-12 pins (3 and 4) are isolated, which prevents signal conflicts. This unique assignment of lines in a single RJ-12 connector is the basis of the adapter's universality.

### Voltage Detection and Switching Circuit

The adapter is equipped with an analog detection circuit for the interface supply voltage on the meter side. The signal from pin 1 (IF_V) is delivered to a voltage comparator (block B4 in the block diagram). This comparator compares the incoming voltage to a set threshold of approx. 4.4 V. On the basis of this measurement, analog switches responsible for configuring the interface power supply and the pull-up resistor are controlled:
- Switch SW1 - switches the power source for the adapter's transceiver circuit (designated as U1) and sets the reference level for the TX line. When the IF_V voltage exceeds the ~4.4 V threshold (i.e. is close to +5 V, as in the P1 interface), comparator B4 sets SW1 to the position that connects U1's power supply to the external IF_V voltage. Otherwise (IF_V below the threshold or not present), SW1 remains in the default position, connecting U1's power to the adapter's internal +3.3 V regulator. Thanks to this solution, the adapter automatically uses the meter's +5 V (if available) to operate at ~5 V logic levels, whereas in cases of lower voltages (such as -4.15 V from a Kamstrup meter or when no external supply is present) it switches to 3.3 V levels.
- Switch SW2 - controls the connection of the pull-up resistor R1 to the RX receive line. In the closed position, SW2 connects resistor R1 between the RX line and the IF_V line (interface voltage). This configuration is required for an open-collector type interface - for example, in the P1 standard the meter's data line (denoted "Data") is an output via an optocoupler or open transistor and requires a pull-up to +5 V in order to read correct logic levels. The adapter provides this pull-up automatically: when B4 detects the presence of +5 V (IF_V, P1 port) and SW1 switches U1's supply to IF_V, simultaneously SW2 closes, connecting R1 and biasing the RX line to +5 V (IF_V) from the meter. This ensures compliance with the P1 requirements - the data line high state is maintained at about 5 V (IF_V), and for the meter to start transmitting data, the adapter holds the request line (Data Request on pin 2) in a high state (~5 V). According to the P1 port documentation, a voltage >4.0 V and <5.5 V on the Data Request line is interpreted as a data request - the adapter meets this requirement by using exactly the meter's supply voltage (nominally +5 V) to drive the request line. If the comparator instead senses a lower voltage (e.g. ~4 V or no external supply), SW2 remains off and the RX line is not pulled up - this corresponds to situations where the meter's data output is actively driven (push-pull type) and does not require a pull-up. For example, the Kamstrup HAN has a push-pull data output with an internal impedance of approx. 1.2 kΩ, capable of actively driving both high and low states, so an external pull-up is not needed there and could even distort the signal - the adapter accounts for this by not adding a pull-up resistor in this mode.

To ensure safe switching of the power supply, diodes preventing backflow are used (e.g. D5 and D8 in the schematic), so that the meter's voltage does not affect the adapter's internal circuits and vice versa. This solution guarantees that regardless of the interface's power source, currents will only flow in the proper direction.

### M-Bus Interface (EN 13757)

The adapter integrates a dedicated discrete M-Bus transceiver (designated U2), enabling both reception and transmission of data as a slave device. Physically, the M-Bus lines are connected to RJ-12 pins 3 (MBUS_N) and 4 (MBUS_P). To ensure correct operation regardless of the polarity of the two bus wires, a bridge rectifier (comprised of diodes D1-D4) is used at the adapter's input. Thanks to this, even if the meter's M-Bus+ and M-Bus- leads are swapped, the adapter will be powered correctly and communication will not be disrupted. This solution complies with the standard - M-Bus device interfaces must tolerate undefined line polarity, which is why a diode rectifier is typically built into a device's input.

The M-Bus transceiver includes mechanisms for regulating its supply voltage and signal detection. The M-Bus operates typically at ~36 V in idle state (mark). The adapter, as a slave device, is powered from this bus - the current drawn by the adapter from the M-Bus line is hardware-limited to approx. 11.5 mA during active communication. This corresponds to about 7 unit loads on the bus (1 unit load = 1.5 mA per the standard). Such power consumption ensures the adapter is properly powered while remaining within the capability of a typical M-Bus master to support up to 250 devices.

For comparison, the M-Bus standard provides for up to 250 slave devices on a 1000 m bus with a capacitance up to 180 nF, each of which in mark state draws ~1.5 mA. A consumption of ~11.5 mA by the adapter is equivalent to a few standard slave devices, leaving a large margin on the bus to power other devices. Furthermore, a hardware current limiter is used in the M-Bus circuit to fulfill the standard's requirements. In summary, in M-Bus mode the adapter behaves like a standard slave device: it is powered remotely from the bus and communicates in half-duplex by modulating current on the line, meeting the physical layer requirements of EN 13757-2/3.

When the adapter is connected to a meter with a wired M-Bus port, the device recognizes the M-Bus interface by the absence of a +5 V supply on pin 1 along with the simultaneous presence of a voltage on the order of tens of volts between pins 3 and 4. In this mode, the adapter does not provide any of its own power to the interface - it is powered by the meter's current (with the meter acting as the M-Bus master). As mentioned, the current drawn is limited to ~11.5 mA, which corresponds to the load of seven typical M-Bus devices. Such a small load guarantees that the adapter will not overload the meter's M-Bus port - even if the meter powers many devices in parallel, there remains a large margin for their power supply.

The data signals on the bus are modulated by current in accordance with the protocol: the adapter listens for signals from the master (meter) via the U2 transceiver, which detects voltage drops of about 12 V as zero bits (space state) - as specified by the standard. In the transmit direction (slave -> master), the adapter, through transceiver U2, loads the line with additional current pulses (~11 mA, up to the set limit) to signal an active state - this is interpreted by the meter as data bits sent by a slave device. The adapter thus ensures full compliance with the M-Bus physical layer according to EN 13757-2, covering both the signal levels and modulation method as well as electrical protection (diode bridge, current limiter, reverse polarity protection). Thanks to this, the adapter can be directly connected to any M-Bus network, acting like a typical slave meter.

### Kamstrup HAN Interface (UART 3.3 V)

Many modern meters (e.g. Kamstrup OMNIPOWER^{®}) have a communication port of the HAN (Home Area Network) type, providing real-time measurement data via UART. A typical Kamstrup port supplies ~4.15 V DC at up to 75 mA (via pin 1 of the adapter's RJ-12), and the data lines operate with 3.3 V UART logic (max speed 9600 bps). Specifically, RJ-12 pin 2 on the adapter serves as the meter's data input (DATA_IN), pin 5 as the meter's data output (DATA_OUT), and pin 6 is ground. The Kamstrup meter's data output is a push-pull type (actively drives both high and low) with a series internal impedance of about 1.2 kΩ.

The adapter recognizes the Kamstrup HAN upon detecting a supply voltage on pin 1 at about 4.0-4.3 V. Because this is below the ~4.4 V threshold, the B4 circuit leaves SW1 in its default position - the U1 transceiver's power and the TX line remain at 3.3 V. The adapter thus switches to 3.3 V operation, compatible with the Kamstrup port's logic. At the same time, SW2 stays off, preventing the RX line from being pulled up to the supply. This is not needed since - as mentioned - the meter's output can hold the line high by itself. If the pull-up resistor R1 were connected in this mode, it would disrupt the interface's operation: it would force a higher voltage (~4 V) than the normal 3.3 V logic level of the meter. The adapter therefore appropriately does not pull up the data line in this mode, allowing the RX line to be driven solely by the meter's transmitter. As a result, the adapter's input exhibits a high impedance as seen from the meter side (>82 kΩ, because the meter itself has an internal 82 kΩ pull-up to 3.3 V on its DATA_IN input).

The adapter's TX line, carrying commands to the meter, operates at 0-3.3 V levels, which is within the meter's DATA_IN acceptable input range (a high level requires a minimum of ~2.0 V).

### NES/MEP Interface (OSGP Alliance)

The MEP (Multipurpose Expansion Port) interface, found for example in NES meters (formerly Echelon), is used for connecting communication extension modules. It is provided as at least a 5-pin screw terminal connector, which when wired to an RJ-12 connector as per the table, has the following pin assignments: pin 4 provides an external device with a supply voltage of about 26 V DC (MEP_PWR), pins 2 and 5 are the meter's data lines (respectively RXD and TXD, UART standard), pin 1 is the MEP_COM_ENABLE input (used for remote activation of the port by an external module), pin 3 is ground, and pin 6 of the RJ-12 remains unconnected. In idle state, the meter's MEP port is inactive - for the meter to start transmitting data on this port, an external device must apply a voltage between 5 V and 12 V to pin 1 (ENABLE), with a minimal current draw of <200 µA.

The adapter according to the invention performs this function using its existing power circuitry: when plugged into the MEP port, 26 V appears on pin 4, which through the internal bridge rectifier and current limiting circuit powers the adapter. In other words, the adapter uses its M-Bus circuitry to also operate with the MEP interface - this is possible because a 26 V signal on pin MBUS_P (4) and ground on MBUS_N (3) appear to the adapter as a constant M-Bus supply.

Next, to activate the meter's port, the adapter must send a signal on the ENABLE line (RJ-12 pin 1). On the adapter, pin 1 is IF_V - in MEP mode no external voltage is provided to it (the MEP port does not supply 5 V there as P1 or Kamstrup do). However, the adapter is prepared for this situation: its internal 3.3 V line is connected to IF_V through a Schottky diode D8. This causes a voltage to appear on pin 1 - because diode D8 drops about 0.3 V, about 3.0 V appears at IF_V (from the internal 3.3 V). Additionally, the fact is utilized that the MEP interface ground is connected to the adapter through diode D1 (within the input bridge on the ground side) - this diode introduces a drop of ~0.7-0.8 V between the meter ground and the adapter's internal ground. As a result, the meter "sees" about 3.8 V at the ENABLE input (~3.0 V + 0.8 V). Experimentally it was found that this is sufficient to activate the MEP interface (even though nominally the specification requires at least 5 V, in practice ~4 V usually activates the port).

After the port is activated, the meter begins transmitting data on pin 5 (TXD), which the adapter receives on the RX line. These signals use UART format with logic levels around 0/5 V. Thanks to the described diode compensation, the signal level (generated at 0-3.3 V levels) sent from the adapter to the meter (adapter's TX line connected to RJ-12 pin 2) is raised by ~0.8 V (through diode D1). Therefore, a high level on the adapter's TX (~3.3 V) is seen by the meter as ~4.1 V, and a low level (~0 V) as ~0.8 V. In this way, the adapter matches the signal levels to the MEP interface's expectations - for the meter, a high level of ~4 V is acceptable (the meter's RXD input requires min. ~3 V, since it nominally operates at 5 V), and a low level ~0.8 V is close to zero (anything below ~1 V is interpreted as low by the meter). Thus, two-way communication proceeds correctly even though the adapter is nominally operating at a lower voltage.

The current drawn from the MEP 26 V line is hardware-limited to a maximum of 40 mA, thereby ensuring safe and compliant operation within the electrical specifications of the NES/MEP interface.

### Use with an IEC 62056-21 Optical Head

The adapter provides an optional capability to connect an external optical head for meter reading via the standard optical port (IEC 62056-21, formerly IEC 1107). This standard defines bidirectional communication using infrared - the head is equipped with an IR emitting diode and a receiving phototransistor, which ensures galvanic isolation from the meter. A typical optical head has leads corresponding to TX, RX, power, and ground. The adapter according to the invention allows easy connection of such a head: the head's phototransistor should be connected between the adapter's IF_V line and RX line, and the IR transmitter diode between the adapter's TX line and ground (with an appropriate current-limiting resistor on the head's side).

When the adapter is powered by an external voltage (in which case the connector provides IF_V voltage), it uses this voltage to bias the phototransistor - this provides proper operating conditions for the optical sensor. The phototransistor, in the presence of light pulses from the meter's transmitter, pulls the RX line up to IF_V in sync with the signal modulation, which the adapter reads as binary data. Thanks to an internal pull-down resistor to ground, the adapter correctly receives the optical data. In the transmit direction, the adapter sends data to the meter by switching the current through the IR diode in the head on and off - the adapter's TX line biases the diode (anode to TX, cathode to GND), and by modulating the current (via a resistor) generates light pulses according to the protocol. The IEC 62056-21 standard specifies e.g. speeds of 300-9600 bps and ASCII frames - the adapter transparently handles these since electrically it behaves like a typical UART<- >IR converter. Thus, the invention enables reading of meters equipped only with an optical port - one simply needs to connect a simple head compliant with the standard to the adapter's connector.

### Optical Pulse Counter Function

The adapter can also serve as a pulse counter for pulses from an external sensor, such as a phototransistor reading the blinking of an LED on a meter (where each blink represents a certain amount of consumed energy). In this configuration, the phototransistor is mounted similarly - between IF_V and RX. This allows the invention to be used even when a meter has no digital communication port, only a pulse LED.

### Universal UART Interface Application

In addition to the meter interfaces described above, the adapter can be used as a standard UART interface converter. For example, it can be connected to a computer's serial port or to an external communication module such as a Wireless M-Bus module. In this case, the adapter's TX and RX lines are connected directly (crossed) to the external device's RX and TX lines, and the grounds are connected together.

If the external device (e.g. microcontroller or modem) provides its own supply voltage (3.3 V or 5 V), it can be connected to the adapter's IF_V pin, or if the external device needs power it can be drawn from the IF_V pin when the adapter is externally powered. If a voltage is applied to the IF_V pin from an external device, the adapter detects this voltage and automatically adjusts its signal levels - for example, upon receiving 5 V it switches to "P1" mode (TTL 5 V) and will send TX signals at ~5 V levels, which is desired when the other device operates at 5 V. If the external device does not provide its own interface power, the adapter can operate using its own 3.3 V - in that case TX/RX signals will be at 3.3 V levels, which is often sufficient since many systems accept 3.3 V as a high level. In this way, the adapter is very versatile: it can serve not only for connection to a meter, but also for integration with various reading systems, always ensuring proper logic level matching and line protection.

## Claims

1. An adapter for smart electricity meters, equipped with a communication interface for reading measurement data, **characterized in that** it has a single physical RJ-12 connector intended for connection to the meter and an adaptive interface circuit that automatically detects the type of communication interface of the connected meter and adapts the electrical parameters of the communication signals to the requirements of that interface, wherein the adapter ensures compatibility with interfaces including P1, M-Bus, Kamstrup HAN and NES/MEP.

2. The adapter according to claim 1, **characterized in that** the adaptive interface circuit comprises an analog circuit for detecting the supply voltage coming from the meter and an electric switch connected thereto, which, depending on the detected voltage level, automatically switches the power supply and reference levels of the transceiver circuits of the adapter between the level of 5 V and the level of 3.3 V, adapting the levels of the TX/RX signals to the requirements of the detected meter interface.

3. The adapter according to claim 2, **characterized in that** it comprises a pull-up resistor which is controlled by an adaptive interface circuit and is automatically connected to the interface voltage only when an interface requiring open collector data line bias is detected, and remains disconnected when an interface having an active push-pull transmitter output is detected.

4. The adapter according to claim 1, **characterized in that** the M-Bus interface circuit comprises a rectifier bridge connected between two bus wires, i.e. the M-Bus+ and M-Bus- lines, connected to the corresponding pins of the RJ-12 connector, ensuring operation independent of the polarity of the bus line connection, and comprises a transceiver compliant with the EN 13757-2 standard, adapted to be powered from the bus and exchange current-modulated data as a slave device.

5. The adapter according to claim 4, **characterized in that** it is equipped with a current limiter for the power supply line of the M-Bus or NES/MEP interface, limiting the current consumption to a value not exceeding 11.5 mA in M-Bus mode and not exceeding 40 mA of continuous current consumption from the 26 V line of the MEP interface.

6. The adapter according to claim 1, **characterized in that** the RJ-12 connector has a specific pin wiring scheme that provides isolation of signals not used in a given interface standard to avoid conflicts and voltage collisions, and furthermore the signal pins of different interfaces are assigned such that the meter transmitter outputs of one standard do not conflict with outputs of another standard.

7. The adapter according to claim 1, **characterized in that** the automatic detection and adaptation circuit of the interface standard operates in hardware, without the need for software initialization, and the change of the electrical configuration of the interface takes place automatically by means of analog elements.

8. The adapter according to claim 1, **characterized in that** it is adapted to cooperate with an optical communication head compliant with the IEC 62056-21 standard, using for this purpose the pins of the RJ-12 connector intended for powering and reading the phototransistor and controlling the infrared transmitting diode, enabling bidirectional optical communication with meters equipped with a standard optical port.

9. The adapter according to claim 1, **characterized in that** it additionally acts as an optical pulse counter by connecting an external optical sensor to the appropriate pins of the RJ-12 connector and counting the pulses resulting from the flashing of the LED of the energy meter, which enables reading of meters without a digital communication interface.
